# EUROPEAN PATENT APPLICATION

(11) **EP 1 351 231 A2**
(43) Date of publication of application: **08.10.2003**
(21) Application number: 03005276.5
(22) Date of filing: 10.03.2003
(51) Int. Cl.: G11B 7/26

(54) **Master disc manufacturing apparatus**

(30) Priority: 04.04.2002 JP 2002102570
(71) Applicant: Pioneer Corporation, Meguro-ku, Tokyo (JP)
(72) Inventor: Kobayashi, Masaki, Koufu-shi, Yamanashi (JP); Kumasaka, Osamu, Koufu-shi, Yamanashi (JP); Kaneda, Hiroki, Koufu-shi, Yamanashi (JP); Kamimura, Kenji, Koufu-shi, Yamanashi (JP); Sone, Masami, Koufu-shi, Yamanashi (JP); Kuriyama, Kazumi, Koufu-shi, Yamanashi (JP)
(74) Representative: Lindner, Manfred Klaus, Dipl.-Phys.

(57) **Abstract**

A manufacturing apparatus includes a deflection adjusting section for adjusting deflection of the exposure beam; a rotation driving section; a distance measuring device (20) for measuring the distance from a predetermined reference position to a distance measuring surface of the turntable during rotation of the turntable; a memory for storing in advance shape values of the turntable; a shaft-vibration value generator for generating shaft vibration values on the basis of the measured distance values and the stored shape values; and a controller for adjusting the irradiation position of the exposure beam on the basis of the shaft vibration values.

## Description

### BACKGROUND OF THE INVENTION

### 1. Field of the Invention

The present invention relates to a manufacturing apparatus for manufacturing a master disc.

### 2. Description of the Related Art

Development has been pursued for various kinds of optical discs including a DVD (Digital Video Disc, or Digital Versatile Disc) having large recording capacity. The optical discs can be used for recording video/audio data and digital information data. Research and development is advanced for increasing the recording capacity of the optical disc of, for example, 12 cm in diameter to a high density of 30 GB (Giga bytes).

For example, a master-disc manufacturing apparatus for manufacturing or cutting an original master for the optical discs is under study to use a laser beam having a shorter wavelength (i.e., short wavelength laser beam) in a visible region and an ultraviolet region as an exposure beam in order to increase recording density. It is also studied to perform cutting of the master disc using a master-disc manufacturing apparatus having an electron beam (i.e., electron beam exposure) in order to improve cutting resolution since the electron beam has a smaller spot diameter than that of the short wavelength laser beam. Further, development of various kinds of large capacity discs such as a magnetic disc is also advanced as well as the optical discs.

In such a high-density disc, for example, the track pitch is a very small value such as 1 µm or less. Therefore, it is necessary to avoid a reduction in accuracy caused by various kinds of fluctuation factors generated in a rotating and moving mechanism of the master-disc manufacturing apparatus as much as possible when manufacturing the master disc. The fluctuation factors are an end-face accuracy and eccentricity, etc. of a turntable for placing a substrate for the master disc thereon, a shaft vibration, backlash, deflection, etc. of a rotation operating system. These fluctuation factors exert an adverse influence on the track pitch.

However, no practical master-disc manufacturing apparatus which has a capability of removing the fluctuation factors to manufacture the master disc of high accuracy was provided so far.

### SUMMARY OF THE INVENTION

The present invention has been made in view of the foregoing problems, and it is an object of the present invention to provide a master-disc manufacturing apparatus for manufacturing a high-density disc of high accuracy.

To achieve the object, according to one aspect of the present invention, there is provided a manufacturing apparatus for manufacturing a master disc by irradiating a substrate placed on a turntable with an exposure beam, which comprises an exposure beam emitting section for emitting the exposure beam; a deflection adjusting section for adjusting deflection of the exposure beam; a rotation driving section for rotating the turntable; a distance measuring device for measuring the distance from a predetermined reference position to a distance measuring surface of the turntable during rotation of the turntable by the rotation driving section; a memory for storing shape values in advance therein, the shape values representing the shape of the distance measuring surface of the turntable; a shaft-vibration value generator for generating shaft vibration values of the rotation driving section on the basis of the measured distance values provided by the distance measuring device and the shape values stored in the memory; and a controller for adjusting the irradiation position of the exposure beam by controlling the operation of the deflection adjusting section on the basis of the shaft vibration values.

### BRIEF DESCRIPTION OF THE DRAWINGS

Fig. 1 is a block diagram showing an optical master-disc manufacturing apparatus using an electron beam according to a first embodiment of the present invention;
Fig. 2 is a block diagram showing a configuration of a laser distance-measuring system of the optical master-disc manufacturing apparatus shown in Fig. 1;
Fig. 3 is a block diagram showing one example of a correcting-signal generating section and a feed control section;
Fig. 4 is a block diagram showing a configuration of a deflection correcting-signal generating section;
Fig. 5 is a block diagram showing one example of a shaft-vibration value generating circuit;
Fig. 6 is a block diagram showing a configuration of a shaft-vibration value generating circuit in a second embodiment of the present invention;
Fig. 7 is a flow chart showing the procedure of an electron-beam deflection control operation;
Fig. 8 is a block diagram showing one example of the configuration of a shaft-vibration value generating circuit in the x-axis direction in a third embodiment of the present invention; and
Fig. 9 is a flow chart showing the procedure of the electron-beam deflection control operation in the third embodiment of the present invention.

### DETAILED DESCRIPTION OF THE INVENTION

The embodiments of the present invention will be described in detail with reference to the drawings. In the figures used in the following explanation, the same reference numerals are designated in substantially equivalent elements.

### First embodiment

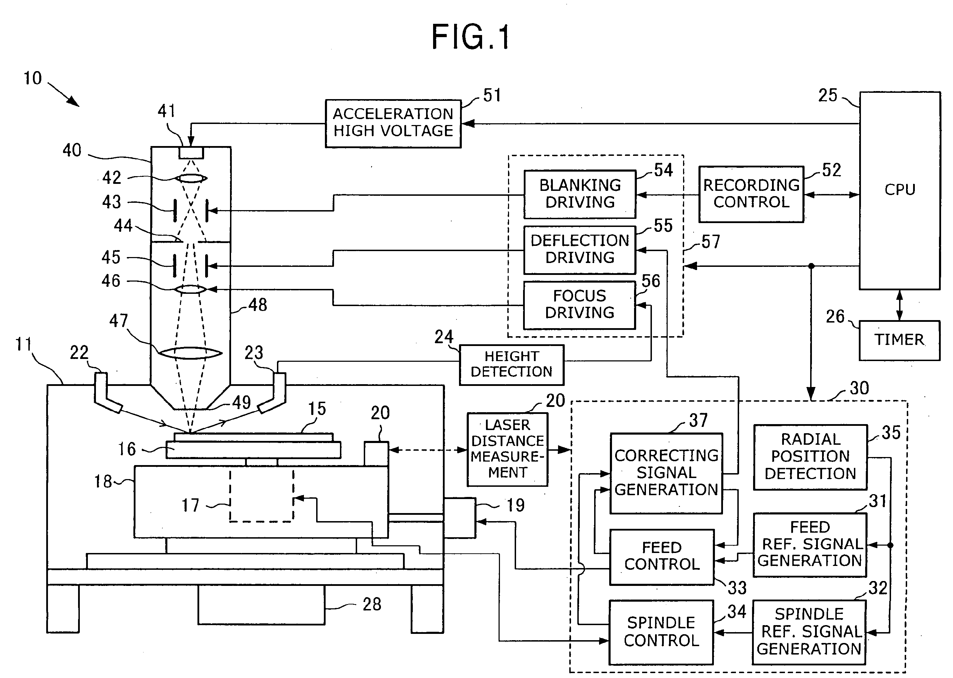

Fig. 1 is a block diagram showing an example of an optical master-disc manufacturing apparatus using an electron beam according to an embodiment of the present invention. The outline of a manufacturing process of such an optical master disc will be described.

The electron beam is used within a vacuum atmosphere, since the electron beam has characteristics greatly damped within the atmospheric pressure. Accordingly, an electron gun, a driving or moving device for the optical master disc (substrate), a transferring device, etc. are used within the vacuum atmosphere.

A substrate, for example, a silicon (Si) substrate is used in manufacturing an optical master disc. The main surface of the silicon substrate is coated with a resist for the electron beam. The substrate coated with the electron-beam resist is rotated within the optical master-disc manufacturing apparatus, and the electron beam modulated by an information data signal is irradiated to the substrate. Thus, the latent image of a fine convex/concave pattern such as a pit, or a groove is formed in a spiral shape.

After the exposure of the electron beam is terminated, the substrate is taken out of the optical master-disc manufacturing apparatus, and development processing of the resist is performed. Then, patterning processing and resist removal processing are performed so that a fine convex/concave pattern is formed on the substrate. An electrically conductive film is formed on the surface of the substrate forming the pattern therein, and electroforming processing is performed so that the master disc (or stamper disc) for the optical disc is manufactured.

As shown in Fig. 1, a vacuum chamber 11, a drive unit for moving the substrate disposed within the vacuum chamber 11, an electron-beam emitting head 40 attached to the vacuum chamber 11 are arranged in the optical master-disc manufacturing apparatus 10.

An optical disc substrate (hereinafter, simply referred to as a disc substrate) 15 for the optical master disc is placed on a turntable 16. The turntable 16 is rotated by a spindle motor 17 as a rotating drive unit for rotating the disc substrate 15 with respect to the axis perpendicular to the principal or main surface of the disc substrate. The spindle motor 17 is provide in a feed stage (hereinafter, simply referred to as a stage) 18. The stage 18 is connected to a feed motor 19 as a movement (transfer) drive unit, and can move the spindle motor 17 and the turntable 16 in a predetermined direction within the plane parallel to the main surface of the disc substrate 15. Optical elements such as an interferometer which is a component of a laser distance-measuring system 20, or a reflecting mirror are arranged on the stage 18 and the turntable 16 to measure a distance by using the laser beam for the distance measurement from a light source within the laser distance-measuring system 20. The laser distance-measuring system 20 will be described later in detail.

The turntable 16 is constructed by a dielectric material, for example, a ceramic material, and has a cylindrical shape. The side surface of the turntable 16 is formed as a mirror surface, and is constructed such that the laser beam from the laser distance-measuring system 20 is reflected on the side surface for distance measurement.

Further, the turntable 16 has an electrostatic chucking mechanism (not shown). Such an electrostatic chucking mechanism is constructed by arranging a ceramic substrate and an electrode constructed by a conductor and disposed within the ceramic substrate for generating electrostatic polarization. A high-voltage power source (not shown) is connected to the electrode, and the electrostatic polarization is generated in the ceramic substrate by applying a positive direct current voltage from the high-voltage power source to the electrode so that adsorption force is exhibited. Namely, the adsorption force is exhibited in the dielectric substrate (e.g., ceramic substrate) by applying the direct current voltage, and the disc substrate 15 is adsorbed and held.

A light source 22, a photodetector 23 and a height detecting portion 24 for detecting the height or level of the main surface of the disc substrate 15 are arranged in the vacuum chamber 11. The photodetector 23, for example, includes a position sensor, a CCD (Charge Coupled Device), etc., and receives the light beam emitted from the light source 22 and reflected from the surface of the disc substrate 15, and supplies a light receiving signal to the height detecting portion 24. The height detecting portion 24 detects the height of the main surface of the disc substrate 15 on the basis of the light receiving signal.

The vacuum chamber 11 is arranged through a vibration proof bench or damper (not shown) such as an air damper so that the transmission of an external vibration is restrained. Further, a vacuum pump 28 is connected to the vacuum chamber 11 so that the chamber interior can be exhausted to produce a vacuum of a predetermined pressure therein.

A driving control section 30 for controlling the operation of a rotation and transfer driving system is arranged within the vacuum chamber 11. The driving control section 30 operates under the control of a CPU 25 which serves as a control section of the entire optical master-disc manufacturing apparatus 10. The CPU 25 is connected to a timer device (simply referred to as a timer) 26. The driving control section 30 performs the driving control on the basis of measured distance data (or a measured distance value) from the laser distance-measuring system 20. A radial-position detecting section 35 is arranged in the driving control section 30. The radial-position detecting section 35 detects the position of an electron beam spot in the radial direction on the basis of the measured distance value. The driving control section 30 has a feed reference-signal generating section 31 for generating a reference signal of the feed amount of the stage 18, and a spindle reference-signal generating section 32 for generating a reference signal of the rotating amount of the spindle motor 17. A feed control section 33 for generating a feed control signal and a spindle control section 34 for performing spindle control on the basis of the reference signals are provided. As described later, a correcting-signal generating section 37 for generating a rotation vibration and feed error signal, and a correcting signal for controlling the deflection of the electron beam is provided.

An electron gun 41, a convergent lens 42, blanking electrodes 43, an aperture 44, beam deflecting electrodes 45, a focus adjusting lens 46 and an objective lens 47 are arranged in this order within the electron beam emitting head 40 for emitting the electron beam. In the electron beam emitting head 40, an electron beam emitting port 49 arranged at the tip of an electron gun sleeve 48 is directed to a space within the vacuum chamber 11, and is attached to the ceiling face of the vacuum chamber 11. The electron beam emitting port 49 is arranged oppositely to the position proximate to the main surface of the disc substrate 15 disposed on the turntable 16.

The electron gun 41 emits an electron beam accelerated to several tens of Kev from a cathode (not shown) to which a high voltage supplied from an acceleration high-voltage power source 51 is applied. The convergent lens 42 converges and guides the emitted electron beam to the aperture 44. A blanking driving section 54 operates on the basis of a signal from a recording control section 52 and performs on-off control of the electron beam by controlling the operation of the blanking electrodes 43. When the voltage is applied between the blanking electrodes 43 to greatly deflect the electron beam passing therethrough, the electron beam is not converged to a diaphragm hole of the aperture 44. The electron beam can be set to the off-state by preventing the electron beam from passing through the aperture 44.

A beam deflection driving section 55 deflects the passing electron beam by applying the voltage between the beam deflecting electrodes 45 in response to a control signal from the CPU 25. Thus, the position of an electron beam spot with respect to the disc substrate 15 can be controlled.

A focus driving section (or a focus lens driving section) 56 performs a focus adjustment of the electron beam spot formed by irradiation on the main surface of the disc substrate 15 on the basis of a detecting signal from the height detecting portion 24.

The electron beam driving section 57 including the blanking driving section 54, the beam deflection driving section 55 and the focus lens driving section 56, the acceleration high-voltage power source 51, the laser distance-measuring system 20 and the vacuum pump 28 are operated on the basis of the control signal from the CPU 25.

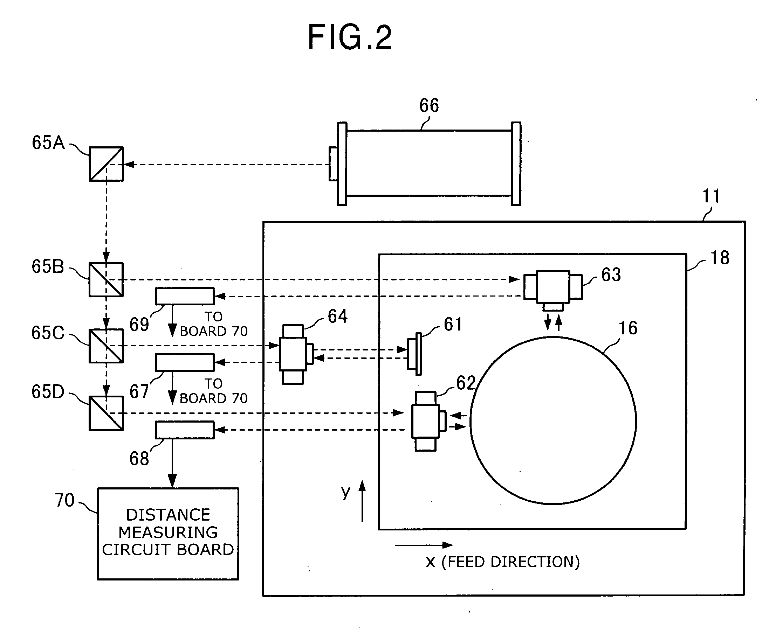

The laser distance-measuring system 20 for detecting the rotating vibration of the turntable 16 will next be described. Fig. 2 is a block diagram showing the configuration of the laser distance-measuring system 20.

The stage 18 is transferred or moved in a predetermined feed direction (the x-axis direction of Fig. 2) within the vacuum chamber 11. A plane reflecting mirror 61 and plane mirror interferometers 62, 63 are mounted on the stage 18. A plane mirror interferometer 64 is provided in the vacuum chamber 11 to be disposed outside the stage 18. A laser light source 66 and beam splitters 65A to 65D for supplying the laser beam to the above-mentioned optical elements are arranged outside the vacuum chamber 11. The laser beam is respectively supplied to the interferometers 62, 63, 64 through the beam splitters 65D, 65B, 65C.

The interferometer 62 constitutes a first distance-measuring system together with a receiver 68 for detecting a change in the position of the side surface of the turntable 16 in the x-axis direction. That is, the laser beam reflected from a mirror surface (side surface) of the turntable 16 is detected by the receiver 68 through the interferometer 62. The detecting signal is supplied to a distance-measuring circuit board 70, and a measured distance value of the x-axis direction representing the distance between the turntable 16 and the interferometer 62 is generated. On the other hand, the interferometer 63 constitutes a second distance-measuring system together with a receiver 69 for detecting a change in the position of the side surface of the turntable 16 in the direction (y-axis direction) perpendicular to the feed direction of the turntable 16. A detecting signal from the receiver 69 is supplied to the distance-measuring circuit board 70, and a measured distance value of the y-axis direction representing the distance between the turntable 16 and the interferometer 63 is generated. The interferometer 64 constitutes a third distance-measuring system for detecting the moving amount of the stage 18 together with the reflecting mirror 61 and a receiver 67. A detecting signal from the receiver 67 is supplied to the distance-measuring circuit board 70, and a measured distance value of the x-axis direction representing the distance between the stage 18 and the interferometer 64 is generated. The moving amount represents the position of the electron-beam spot in the x-axis direction. The optical elements such as the above-described interferometers, the reflecting mirror, the beam splitters, and the receivers are arranged such that the optical paths of the laser beam are approximately located in the same plane.

As mentioned above, measured distance values generated in the distance-measuring circuit board 70 on the basis of the detecting signals from the receivers 67, 68, 69 are sent to the correcting-signal generating section 37. A correcting signal for controlling the deflection of the electron beam is generated in the correcting-signal generating section 37, and is supplied to the beam deflection driving section 55.

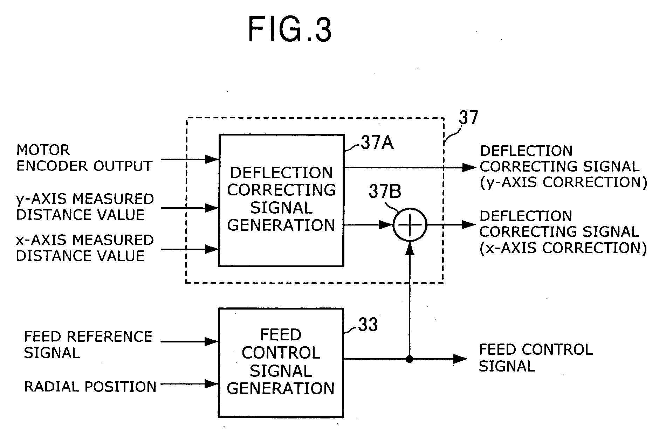

Fig. 3 is a block diagram showing one example of the correcting-signal generating section 37 and the feed control section 33. The correcting-signal generating section 37 has a deflection correcting-signal generating section 37A. The deflection correcting-signal generating section 37A generates a correcting signal for correcting the deflection of the electron beam by using a rotation signal from the spindle motor 17 and the measured distance values of the x-axis and y-axis directions from the laser distance-measuring system 20. On the other hand, the feed control section 33 generates a feed control signal by using a feed reference signal and a radial position signal representing the position of the electron beam spot in the radial direction. For example, in the case of CLV (Constant Line Velocity) control, the feed reference signal according to the detected radial position is generated, and the feed control signal is generated such that an amount of error between the feed reference signal and the feed position (the measured distance value from the third distance-measuring system) is zero.

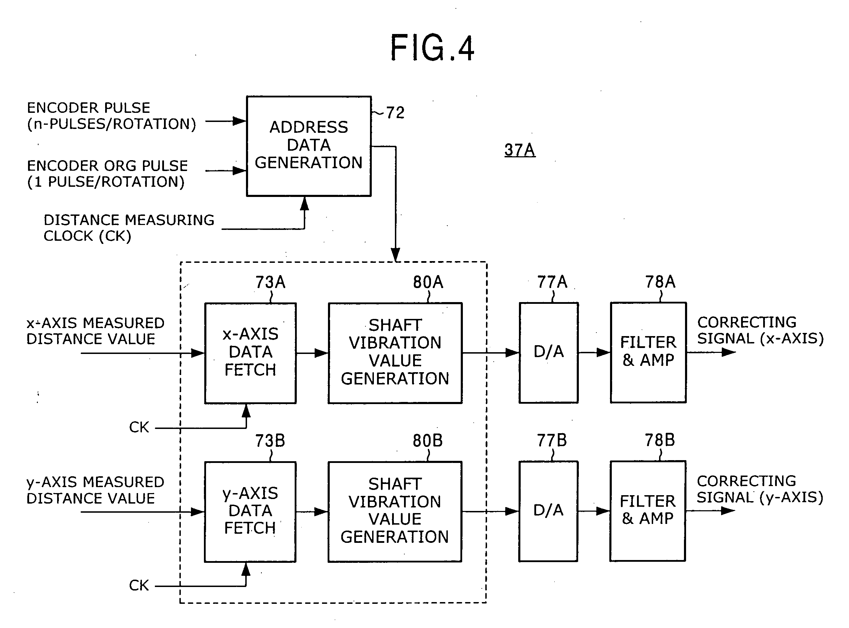

Fig. 4 is a block diagram showing the configuration of the deflection correcting-signal generating section 37A. An encoder pulse signal (n-pulses/rotation, e.g., 4096 pulses/rotation) representing the rotation angle of the spindle motor 17, an encoder pulse reference signal (e.g., 1 pulse/rotation) representing an angular position as a reference position of the rotation, and a clock signal (CK) of the laser distance-measuring system 20 are first supplied to an address data generating section 72. The address data generating section 72 counts the encoder pulses with the encoder pulse reference signal as a reference. For example, an address of 10 bits (=1024) corresponding to the rotation angle is generated from the count value for performing data processing every predetermined rotation angle. The generated address is supplied to each of processing circuits within the deflection correcting-signal generating section 37A by way of an address data bus.

The measured distance value of the x-axis direction from the laser distance-measuring system 20 is fetched in an x-axis data fetch section 73A. A shaft vibration value is generated in a shaft-vibration value generating circuit 80A by using the measured distance value in the x-axis direction.

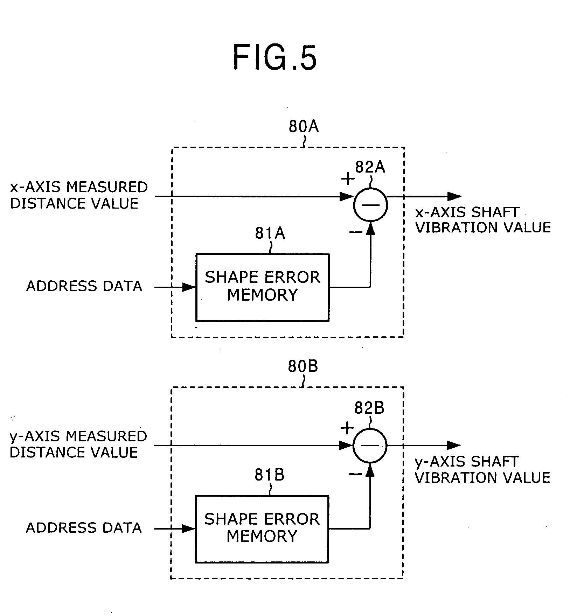

Fig. 5 is a block diagram showing one example of the shaft-vibration value generating circuit 80A. The shaft-vibration value generating circuit 80A includes a mirror-surface shape error memory (hereinafter, simply referred to as a shape error memory) 81A. Data values (i.e., shape values) representing the shape of the side surface or curved surface (i.e., mirror surface) of the turntable 16 measured in advance are stored in the shape error memory 81A. When the turntable 16 has a cylindrical shape as in the embodiment, shape error values may be stored in stead of the shape values as the data values in which the shape error value for each address represents the deviation of the shape of the side surface as a distance-measuring surface from a perfect circle (i.e., round circle) as a reference circle. For example, a sectional shape (i.e., circular shape) on design of the turntable 16 is supposed as a reference circle, and the distance values are measured with reference to the positions on the reference circle. In the shaft-vibration value generating circuit 80A, the shaft vibration value is generated by subtracting the shape error value from the measured distance value in the x-axis direction by a subtracter 82A for each address. In other words, the shaft vibration values for every addresses in the x-axis direction can be calculated by subtracting the shape errors due to the mirror-surface shape from the respective measured distance values in the x-axis direction for the mirror surface of the turntable 16.

The x-axis shaft vibration value generated in the shaft-vibration value generating circuit 80A is converted to an analog signal in a digital/analog (D/A) converter 77A. Then, a beam deflection correcting signal in the x-axis direction is generated in a filter/amplifier section 78A having a predetermined frequency band and a predetermined gain.

The x-axis direction deflection correcting signal is added to the above feed control signal in an adder 37B, and is then supplied to the deflection driving section 55, and a beam deflection correction with respect to the shaft vibration of the x-axis direction is made.

Similar processing is performed with respect to the measured distance values in the y-axis direction. More particularly, a y-axis shape error memory 81B and a subtracter 82B are arranged in a shaft-vibration value generating circuit 80B, and a beam deflection correcting signal of the y-axis direction is generated. The y-axis deflection correcting signal is supplied to the deflection driving section 55, and a beam deflection correction with respect to the shaft vibration of the y-axis direction is performed.

### Second embodiment

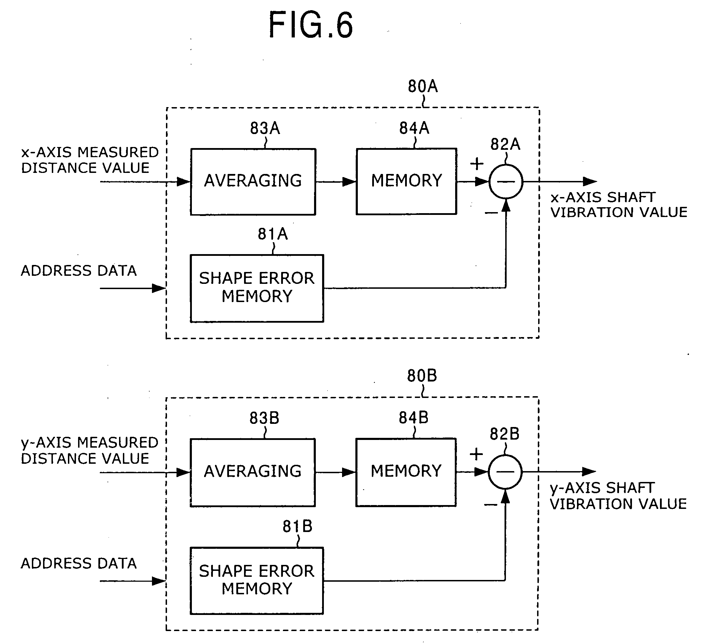

Fig. 6 is a block diagram showing the configuration of shaft-vibration value generating circuits 80A, 80B in a second embodiment of the present invention. The configuration of the other elements or sections in the optical master-disc manufacturing apparatus 10 are similar to those in the first embodiment.

The shaft-vibration value generating circuit 80A of the x-axis direction in the embodiment is further provided with an averaging circuit 83A and a memory 84A. Similarly, the shaft-vibration value generating circuit 80B of the y-axis direction is further provided with an averaging circuit 83B and a memory 84B.

Shaft vibration value generation processing of the x-axis direction will be described with reference to Fig. 6. With respect to the measured distance values of the x-axis direction, an average value corresponding to the rotating position of the turntable 16 is calculated in the averaging circuit 83A. More particularly, the average value is calculated for each address corresponding to the rotating position. The calculated average values for the addresses are stored in the memory 84A. Further, the shaft vibration value is generated by subtracting the shape error value from the average value of the measured distance value in the x-axis direction for each address in the subtracter 82A. Similar processing is performed with respect to the measured distance values in the y-axis direction.

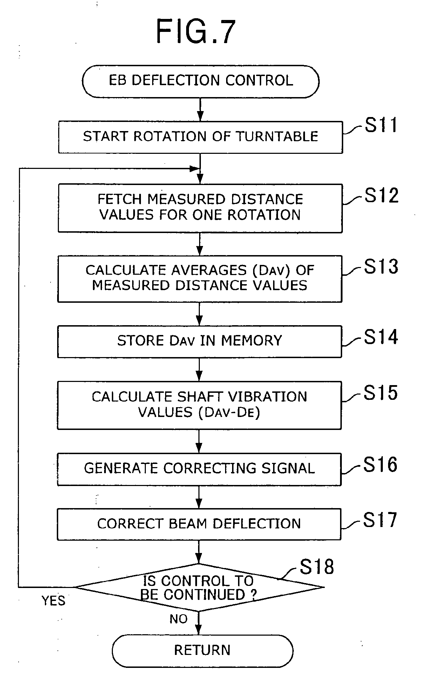

An electron beam (EB) deflection control operation in the embodiment will next be described in detail with reference to the flow chart of Fig. 7. The disc substrate 15 is arranged in a predetermined position, and the rotation of the turntable 16 is then started (step S11). Then, the measured distance values (in the x-axis and y-axis directions) for one rotation of the substrate 15 are fetched every predetermined rotation angle from a reference rotating position of the turntable 16 (step S12). In other words, the measured distance values are fetched in correspondence with the respective address (i.e., rotating position). Then, the average values in both the x-axis and y-axis directions are calculated (step S13) from address to address. The average values are calculated with respect to the measured distance values of predetermined number of rotations (e.g., n-rotations) by using, for example, a moving average method. The average values of the measured distance values every address (i.e., address "i"; i=1,2,...) in the respective x-axis and y-axis directions are set to D_{AV},_{X}(i) and D_{AV},_{Y}(i) (hereinafter also simply written as D_{AV}) and are stored in the memory 84A (step S14).

The shape error values D_{E},_{X}(i), D_{E},_{Y}(i) (hereinafter, also simply written as D_{E}) stored in the shape error memories 81A, 81B in advance are respectively subtracted from the average values D_{AV} of the measured distance values stored in the memory 84A in the subtracters 82A, 82B, and the shaft vibration values in the x-axis and y-axis directions are calculated on an address-by-address basis (step S15).

Beam deflection correcting signals (in the x-axis and y-axis directions) are generated from the calculated shaft vibration values (step S16), and the deflection of the electron beam is corrected on the basis of the deflection correcting signals (step S17). It is then determined whether the deflection control is to be continued or not (step S18). When it is determined that the deflection control is continued, control proceeds to the step S12. In contrast to this, when it is determined that deflection control is no longer to be continued, control is returned to the main routine.

Accordingly, the shaft vibration can be corrected by removing the shape error and by removing a noise component such as electric noise asynchronous to a rotation from the position change of the rotating system by performing averaging processing. Further, for example, it is possible to cancel a change with the passage of time due to thermal expansion, etc. by using the moving average method and the like as mentioned above. Accordingly, in accordance with the present invention, adverse influence due to the shaft vibration of the disc substrate can be removed, and a manufacturing apparatus capable of manufacturing the master disc of high accuracy can be provided. Further, the stable and reliable correction can be performed since the measuring distances are short. Further, the shaft vibration can be accurately detected on a real-time basis, and the correction can be made at high speed by a digital calculation.

### Third embodiment

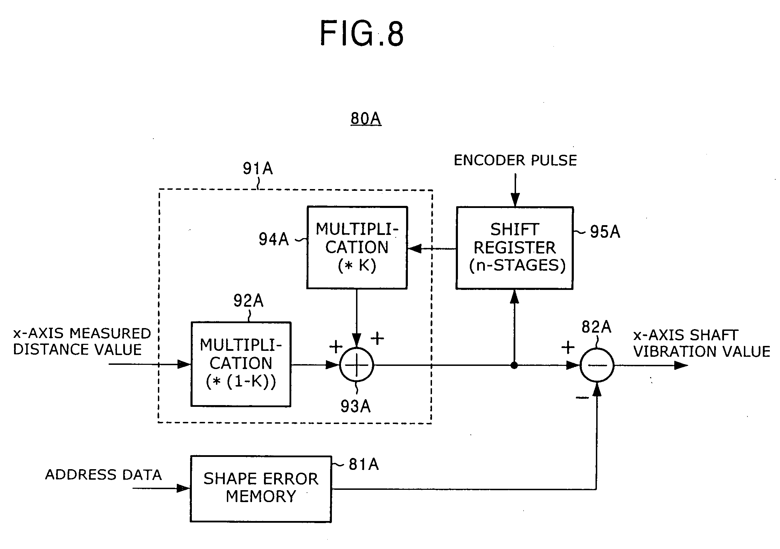

Fig. 8 is a block diagram showing one example of the configuration of a shaft-vibration value generating circuit 80A of the x-axis direction in a third embodiment of the present invention. For brevity and convenience of the drawings, a shaft-vibration value generating circuit 80B of the y-axis direction is omitted, but has a similar configuration. The other configuration of the optical master-disc manufacturing apparatus 10 are similar to those in the first embodiment.

A measured distance value (i.e., the present measured distance value) of the x-axis direction supplied from a data fetch section 73A is sent to a weighted average calculating section 91A. The weighted average calculating section 91A calculates a weighted average value (weighting mean value) of the present measured distance value and an accumulated measured distance value, and obtains a new accumulated measured distance value.

The accumulated measured distance value from the weighted average calculating section 91A is delayed by a time corresponding to one rotation of the turntable 16 in a delay device such as a shift register 95A and is supplied to the weighted average calculating section 91A as the accumulated measured distance value. An FG (frequency generator) pulse signal (i.e., pulse signal responsive to the rotation angle) is supplied from the spindle motor 17 to the shift register 95A of n-stages, and the previous accumulated measured distance value is supplied to the weighted average calculating section 91A in accordance with the pulse signal. The previous accumulated measured distance value is multiplied by a predetermined coefficient (K) in a multiplier 94A. On the other hand, the present measured distance value supplied from the data fetch section 73A is multiplied by a coefficient (1-K) in the multiplier 94A. The multiplied results are added in an adder 93A, and a weighted average calculation of the present measured distance value and the accumulated measured distance value is executed. The obtained weighted average value is set to a new accumulated measured distance value. When the predetermined coefficient is set to 0.5 (K=0.5), the weighted average calculating section 91A calculates an arithmetic mean of the present measured distance value and the accumulated measured distance value.

The new accumulated measured distance value represents a synchronous component. In the subtracter 82A, a shape error value stored in the shape error memory 81A is subtracted from the present measured distance value. With respect to the measured distance value of the y-axis direction, similar processing is performed. Thus, the shaft vibration values of the x-axis and y-axis directions are obtained. Beam deflection correcting signals (in the x-axis and y-axis directions) are generated from the shaft vibration values.

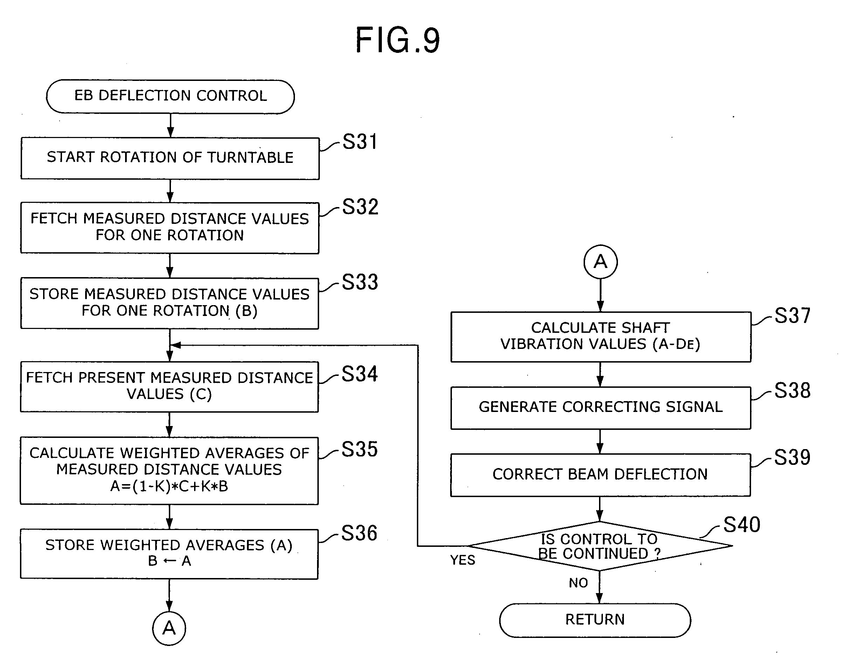

An operation of electron-beam deflection control will next be described in detail with reference to the flow chart of Fig. 9. For brevity and convenience of the description, the beam deflection control in the x-axis direction will be described.

In the first step, the disc substrate 15 is placed in a predetermined position, and the rotation of the turntable 16 is then started (step S31). The measured distance value in the x-axis direction for one rotation is fetched every predetermined rotation angle on the basis of an encoder pulse signal from the reference rotating position of the turntable 16 (step S32). In other words, the measured distance values are fetched in correspondence with the respective addresses (i.e., rotating positions). The fetched measured distance values "B" (=B(i), i=1, 2, ...) for one rotation in the x-axis direction are then stored in the shift register 95A of n-stages on the basis of the encoder pulse signal (step S33). Then, the measured distance values "C" (=C(i), i=1, 2, ---) for one rotation are further fetched. In other words, the "present" measured distance values are fetched (step S34).

Then, weighted average values A=(1-K)×C+K×B (A=A(i), i=1, 2, ...) of the measured distance values are calculated (step S35). Further, the calculated weighted average values "A" are sequentially stored in the shift register 95A (step S36). The calculated weighted average values "A" constitute a synchronous component, and are used as accumulated measured distance values (i.e., "B") for performing the weighted average calculation with respect to the next measured distance values "C" for one rotation. On the other hand, shape error values D_{E}(i) stored in the shape error memory 81A in advance are subtracted from the respective weighted average values "A" by the subtracter 82A, and the shaft vibration values for the addresses in the x-axis direction are calculated (step S37).

A beam deflection correcting signal in the x-axis direction is generated from the calculated shaft vibration values (step S38). With respect to the y-axis direction, the shaft vibration values are similarly calculated, and a beam deflection correcting signal in the y-axis direction is generated from the calculated shaft vibration values. The deflection of the electron beam is corrected on the basis of the deflection correcting signals (step S39). It is then determined whether the deflection control is to be continued or not (step S40). When the deflection control is determined to be continued, it proceeds to the step S34, and the above-described procedure is repeated. In contrast to this, when it is determined in the step S40 that no deflection control is to be continued, control is returned to the main routine.

Accordingly, in accordance with the present invention, a control error can be reduced so that the manufacturing apparatus of high accuracy can be realized, since the synchronous component is updated every rotation. Further, it is possible to provide a high accuracy master-disc manufacturing apparatus in which required memory capacity is small and the shaft vibration can be corrected on a real-time basis by a simple configuration.

The optical master disc is described as the master disc as an example. However, the present invention is not limited to this, but can be also applied to an apparatus for manufacturing a magnetic master disc, etc. by using the electron beam. Further, the present invention can be also applied to an apparatus using the laser beam as an exposure beam.

As can be seen from the above description, in accordance with the present invention, it is possible to provide a manufacturing apparatus having a capability of removing an adverse influence due to the shaft vibration of a rotating system and a capability of manufacturing a high accuracy master disc.

The invention has been described with reference to the preferred embodiments thereof. It should be understood by those skilled in the art that a variety of alterations and modifications may be made from the embodiments described above. It is therefore contemplated that the appended claims encompass all such alterations and modifications.

## Claims

1. A manufacturing apparatus for manufacturing a master disc by irradiating a substrate placed on a turntable with an exposure beam, comprising:
an exposure beam emitting section for emitting said exposure beam;
a deflection adjusting section for adjusting deflection of said exposure beam;
a rotation driving section for rotating said turntable;
a distance measuring device for measuring the distance from a predetermined reference position to a distance measuring surface of said turntable during rotation of said turntable by said rotation driving section;
a memory for storing shape values in advance therein, the shape values representing the shape of said distance measuring surface of said turntable;
a shaft-vibration value generator for generating shaft vibration values of said rotation driving section on the basis of the measured distance values provided by said distance measuring device and the shape values stored in said memory; and
a controller for adjusting the irradiation position of said exposure beam by controlling the operation of said deflection adjusting section on the basis of said shaft vibration values.

2. A manufacturing apparatus according to claim 1, wherein said distance measuring device measures the distance to said distance measuring surface every predetermined rotation angle of said substrate, and said shaft-vibration value generator generates the shaft vibration value every said predetermined rotation angle.

3. A manufacturing apparatus according to claim 1 or 2, wherein said shaft-vibration value generator generates said shaft vibration value by subtracting the shape values stored in said memory from the distance to said distance measuring surface.

4. A manufacturing apparatus according to claim 1 or 2, wherein said shaft-vibration value generator generates each of said shaft vibration values by subtracting the shape value stored in said memory from an average value of the measured distance value every predetermined rotation angle provided by said distance measuring device.

5. A manufacturing apparatus according to any one of claims 1 through 4, wherein said shaft-vibration value generator calculates a weighted average value of the present measured distance value provided by said distance measuring device and an accumulated measured distance value, and calculates said weighted average value by using the weighted average value provided before by one rotation of said substrate as said accumulated measured distance value in the calculation, and generates said shaft vibration value by subtracting the shape value stored in said memory from said weighted average value.

6. A manufacturing apparatus according to any one of claims 1 through 5, wherein the manufacturing apparatus further comprises a translational moving section for relatively moving said exposure beam emitting section and said turntable in a predetermined direction within the plane parallel to the main surface of said substrate.
